# EUROPEAN PATENT APPLICATION

(11) **EP 1 786 027 A2**
(43) Date of publication of application: **16.05.2007**
(21) Application number: 06008902.6
(22) Date of filing: 28.04.2006
(51) Int. Cl.: H01L 21/3065

(54) **Plasma etching of tapered structures**

(30) Priority: 14.11.2005 EP 05024818
(71) Applicant: Schott AG, 55122 Mainz (DE)
(72) Inventor: Ngo, Ha-Duong, DE-10118 Berlin (DE); Seidemann, Volker, Dr., DE-10437 Berlin (DE); Studzinski, Daniel, DE-10651 Berlin (DE); Lange, Martin, DE-12043 Berlin (DE); Hiess, André, DE-01309 Dresden (DE)
(74) Representative: Herden, Andreas F.

(57) **Abstract**

The invention relates to a method of plasma etching substrates, in particular of etching tapered passages through substrates, using a process gas comprising at least one halogenide and oxygen.

## Description

### Field of the Invention

The invention relates to a method of plasma etching substrates, in particular micro-electronic semiconductor substrates.

### Background of the Invention

Plasma etching processes are commonly used to etch layers in the production of integrated circuits. Reactive Ion Etching was the main technology, but recent advanced techniques such as electron cyclotron resonance (ECR), and inductively coupled plasmas (ICP), were introduced, using magnetic fields to enhance plasma densities.

It is believed that plasma etching is based in part on a chemical etching. This means that chemical reactions take place between atoms of the bulk material and gas atoms to form a molecule, which then is removed from the substrate. Due to an applied DC voltage, there also are some sputtering effects which are believed to be smaller than the chemical etching effects. Further, it is believed that the chemical etching process is increased or supported by ion bombardment. Both effects combined result in a synergy effect providing an enhanced etching rate.'

Main steps in the etching process are:
1. formation of reactive particles,
2. arrival of the reactive particle at the surface to be etched,
3. adsorption of the reactive particle at the surface to be etched,
4. chemical adsorption of the reactive particle at the surface,
5. formation of a molecule,
6. desorption of the molecule,

With increasing device density on or within a chip, there is an increased overall functionality, e.g. in applications like MEMS, RF circuits, where microsensors, microactuators are integrated, often also with digital and analog electronic components. This increased complexity leads to smaller bond pads on devices and advanced packaging challenges.

One of the essential features of image sensors packages and MEMS or solar cells are the backside contacts. Optical devices require on the one hand side an interface with the environment without any restriction caused by the packages. However, on the other hand side, optical devices also require a protection against environmental influences. Even for AeroMEMS which need an interface to the environment to detect or to modify the flow behaviour, precisely defined openings or passages are essential for the functionality of these devices.

One problem of the state of art etching methods is the bowing of etched passages. This means that the diameter of etched passages increases below the mask and after removing the mask, a small collar extends along the edges of etched structures. Accordingly, bowing shows pronounced disadvantages for the size of etched structures and causes problems in subsequent manufacturing process steps.

### Object of the Invention

It is an object of the invention to provide a method of etching of at least parts of a substrate which is reliable and improves a micro size structuring precision.

Furthermore, it is an object of the invention to reduce bowing of etched passages or at least to control the size of bowing based on parameters of the etching method.

It is further an object of the invention to provide an etching method which enables etching of tapered passages and to define the sidewall angle of tapered passages based on the etching method.

### Summary of the Invention

This object is achieved by a method of plasma etching of at least parts of a substrate in accordance with independent claims 1 and 41 to 50.

Advantageous refinements are subject of the respective dependent claims.

According to the invention, there is provided a substrate and at least one mask is applied onto the substrate. This mask can be structured after deposing on the substrate or an already structured mask is applied.

The structure defines or comprises openings in the mask. These openings might have different shapes, e.g. round structures to form circular passages or rectangular structures to define stripe conductors or passages..

By performing a plasma etching process, material is removed from the substrate at least in the openings.

According to the invention, a process gas is used comprising at least one halogenide and oxygen.

The inventors have discovered that it is possible with this gas mixture to etch micro-size structures, especially passages for backside-contacting electronic devices. The inventive method provides tapered passages with sidewall angels substantially independent from the material of the substrate. This means that the sidewall angle neither is defined by the crystal structure nor follows the crystal texture.

Furthermore, it is possible to form passages substantially without overhang (bowing) below the mask.

According to a preferred embodiment of the invention, the amount of oxygen in the process gas is less than 40 % preferably below 20 %, in particular preferred below 25 %, the portion in defined in volume percentage. The ratio of the said oxygen to the said halogenide is less than 30 %, preferably below 25 %, in particular preferred below 20 % (ratio in volume percentage). The inventors discovered that with an amount of oxygen below 30 % of a SF₆/O₂- mixture it is possible to etch micro-sized passages substantially without any overhang or bowing. The volume of the gasses is measured as standard cm³ (sccm).

The halogenide is provided in particular as a sulfur halogenide, especially as SF₆.

According to the invention the term halogenide is defined as molecules or atoms comprising one or more halogen atoms. Moreover, said halogen atoms can be chemically bonded in molecules or can be provided as ions, for instance as ions within a plasma.

The method according to the invention relates to various substrates, in particular semiconductor materials like silicon wafers.

According to a preferred embodiment of the invention, a photoresist is used as mask.

Such masks can be structured with photolithographic processes, especially using steppers, which enable structures with a precision of 10µm or even better, i.e. a precision of only a small fraction of a micrometer, as f.i. 0,2 µm or even 0,1 µm.

The inventors discovered that the selectivity of SiOₓ is very good. It is possible to etch on photosensitive resists.

After etching the substrate, the mask can be easily removed.

According to an embodiment of the invention, the substrate is etched in at least two etching steps.

In particular, a first etching step can be performed having a higher etching rate than a following second etching step. With the said first etching step it is possible to etch deep structures in a fast manner. Due to the fact, that high etching rates may result in a reduced accuracy, the process will be finished in one or several further etching steps with lower etching rate.

The inventors discovered that by reducing the portion of oxygen in the second etching step, the accuracy can be improved.

As a last step, it is possible to etch with a halogenide gas as process gas only, being the single process gas.

Alternatively, at least one passage (via hole) can also be etched into the substrate in a single etching step. Especially by means of added gases for passivation, for example CHF₃ or C₄F₈, it is possible to etch passages of high accuracy, which are substantially free of any overhang or bowing.

With the method according to the invention, various etching rates are possible, in particular the etching rate can be varied between 5 and 500 µm/min, preferably between 7 and 100 µm/min, and particularly preferred between 8 and 20 µm/min.

The adding of passivation gasses like CHF₃ and C₄F₈ to the process gas improves the manufacturing accuracy and further reduces an overhang formation below the mask. Preferably, these passivation gases include at least one carbon comprising chemical compound.

The sidewall angle can be controlled by parameters of the etching process. It is possible to form sidewall angles between 50° to nearly 90°. The inventors discovered that with an etching method according to the invention, the sidewall angle does not follow the crystal structure of said substrate.

For most applications steep passages are desired. But an sidewall angle of 90° might be to steep to enable deposition of conductive or non-conductive material in further process steps. Accordingly, the sidewall angle is kept preferably between 75° and 85°.

The roughness of the sidewalls of the passages can be reduced to below 200 nm, preferably to below 100 nm, in particular preferred to below 50 nm (peak to valley) providing a standard surface roughness Rₐ of the sidewalls below 100 nm, preferably below 30 nm, in particular below 10 nm (Rₐ).

It is possible to form passages or via holes of very small diameters between 10 µm and 500 µm, preferably between 15 and 100 µm, particularly preferred between 18 and 70 µm.

According to the invention, the interpretation of diameter is not limited to substantially circular passages. It can be applied to essentially all shapes of passages wherein the diameter is defined as distance between the opposing sidewalls of the passage.

According to the terms of this description a passage defines an overhang below said mask, when the diameter of said passage in the neighborhood of said mask opening is larger than the diameter of said mask opening.

According to the invention, it is possible to form passages, wherein in the neighborhood of the mask opening the difference of the diameter of the opening and the diameter of the passage is less than 10 µm, preferably less than 5 µm, in particular preferred less than 2 µm.

A possible overhang can be controlled inter alia by the power of the plasma source.

Especially for removing a remaining overhang, the substrate can be thinned.

With the method according to the invention, the substrate can be etched to a depth of between 5 µm and 500 µm, preferably between 20 and 200 µm, in particular preferred between 80 and 160 µm.

As a plasma source for generating the plasma, nearly all kinds of plasma sources can be used, in particular inductively coupled plasma (ICP) sources are suitable.

By structuring the mask with a stepper, an accuracy of better than 10 µm can be achieved.

To improve the surface roughness of the substrate, the substrate might be smoothed in a further process step.

The temperature of the substrate during said plasma etching process is hold below 200 °C, preferably below 150 °C, in particular preferred below 120 °C. Accordingly, the method according to the invention is suitable for microelectronics.

To decrease the substrate temperature, the etching process can be performed discontinuously, in particular pulsed.

In particular, the substrate can be etched, in a KOH etching process.

After etching of the substrate, conductive stripes can be formed, for instance by depositing at least one conductive layer onto the substrate.

Finally, the substrate can be coated with a passivation layer.

The invention is suitable for various applications, such as electronic components, in particular wafer level packages, image sensors, e.g. CCD chips, Micro Electro Mechanical Systems (MEMS) or also for microfluidic systems.

Due to the fact that the sidewall angle is not or only to a minor amount influenced by the material of the substrate, also filters, in particular molecular sieves, can be manufactured. Such filters can be provided with sidewall angels of nearly 90° in order to form substantially trough-going passages.

The invention is suitable for photosensitive device backside contacting, in particular of charge-coupled photosensitive devices (CCD).

By directly contacting each pixel, the signal noise of image devices can be reduced considerably.

The signals of each pixel can be amplified by a cascade type amplifier or a photomultiplier, in particular a secondary electron multiplier.

The amplified signal can be transmitted by a bucket brigade circuit. Due to the fact, that the bucked brigade circuit, processes amplified signals, the signal noise is reduced significantly.

Preferably, the above mentioned electronic components are provided as integrated circuits, in particular as thin film integrated circuits.

### Brief Description of the Drawings

Figs. 1 to 6 show steps of etching a substrate according to an exemplary embodiment of the invention,
Figs. 7 to 10 show schematically a method of contacting wafer level packaged image sensors,
Figs. 11 and 12 show two images of passages etched with the same recipe but with different etch times,
Figs. 13 to 15 show a multistep etch method,
Fig. 16 shows a result of a multistep etching method according to Figs. 13 to 15.
Fig. 17 shows a picture of the result of the inventive etching method,
Fig. 18 shows schematically a plasma source adopted to be used for plasma etching according to the invention.
Fig. 18a shows schematically an inductive coupled plasma source.
Fig. 19 shows schematically a cross section of an area of a photosensitive device.
Fig. 20 to Fig. 25 show schematically flow charts of an exemplary method of wafer level chip size packaging, wherein a wafer is packaged and contacted using, inter alia, etching methods according to the invention.

### Detailed Description of preferred Embodiments

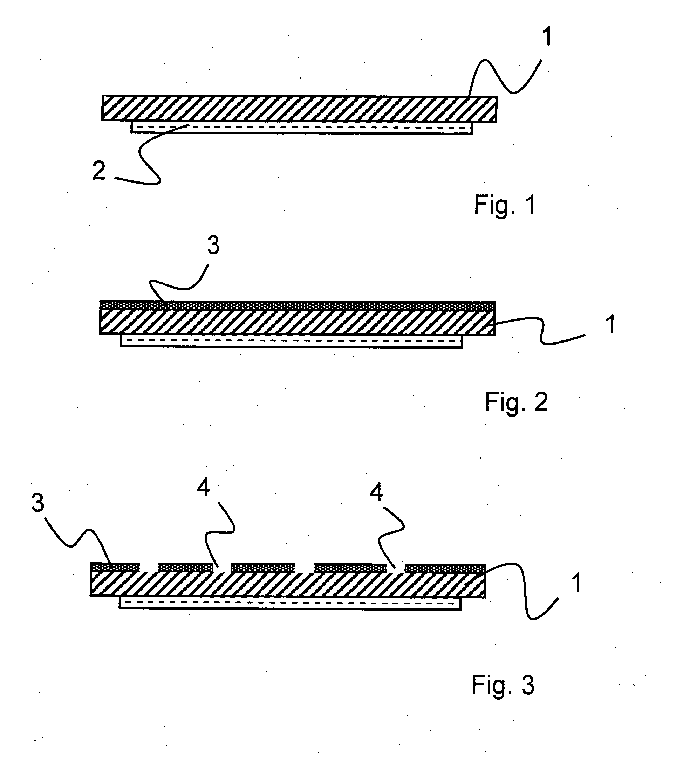

Fig 1 to Fig. 6 show schematically the steps of etching of parts of a substrate according to an exemplary embodiment of the invention.

As shown in Fig. 1, there is provided a substrate 1. The substrate 1 according to this embodiment of the invention is a wafer comprising electric components 2 on its front side. The electronic components 2 may comprise e.g. an image sensor or in general electronic, opto electronic, micro fluidic or micro mechanical structures.

As shown in Fig. 2, a photolithographic mask 3 is applied on the backside of the substrate 1.

As a next step according to Fig. 3, the mask 3 is structured to define openings 4 on said substrate 1. With a photolithografic arrangement or a stepper device (not shown), it is possible to apply micro sized structures with an accuracy of 10 µm or to apply sub micron sized structures with an accuracy of 0,1 µm, respectively.

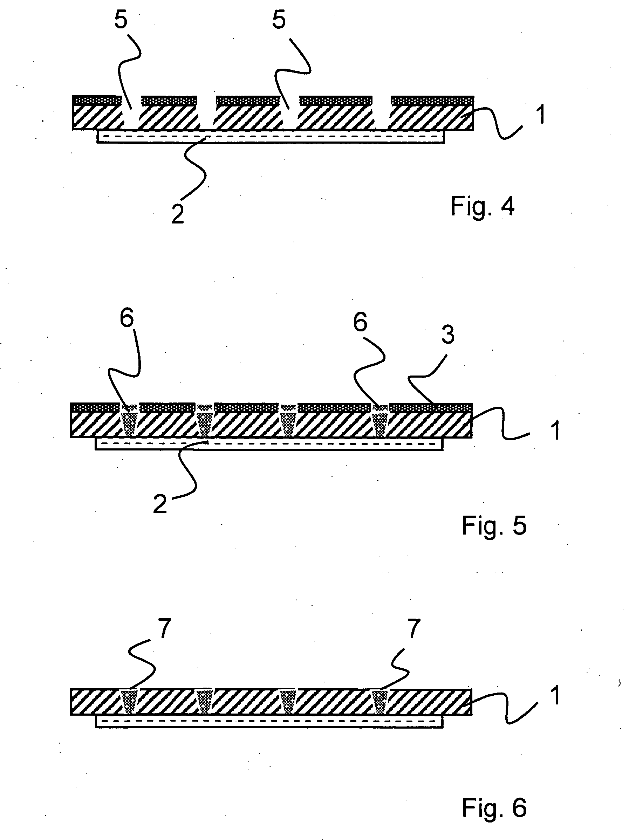

Referring to Fig. 4, passages 5 are etched through the openings of the mask 3 into substrate 1. According to the invention, there is used a process gas for etching comprising SF₆ and up to 30 % O₂. These passages may extend through the whole substrate like vias or may end in a predefined depth of within substrate 1.

The inventors discovered that the sidewall angle of the tapered passages substantially does not depend on the material of the substrate and can be controlled based on the process parameters.

Further, the size of the overhang bowing can be,controlled with the inventive etching method.

The basic idea of this plasma anisotropic etching method is the balance between the sidewall passivation and the bottom etching.

Plasma etching of tapered passages can be performed on HR (High Rate) ICP (Inductive Coupled Plasma) plasma kit tools. As etching gas SF₆ is used, achieving etching rates up to 25 µm/min in silicon. C₄F₈, O₂, and CHF₆ are used as passivation gases.

The plasma etch process depends to a certain extend on the chemical reaction of the plasma gasses with substrate 1. The etch rate is depends on the diffusion rate of the reactive species generated by the plasma to the etch front and depends further on the diffusion rate of the formed etching products to escape from the etch front. The rates of diffusion to and from the etch front are reduced relative to the shallow silicon structures. This reduces the etching rate, as the etch depth increases.

As an alternative, cryogenic plasma etching could also be used for etching of tapered passages 5. The mechanism used in cryogenic etching is a combination of formation of blocking layer and reduction of the reaction probability of radicals at silicon surface. A disadvantage of this method is the cryogenic temperature. This low temperature is not suitable for many applications due to the respective temperature limitations.

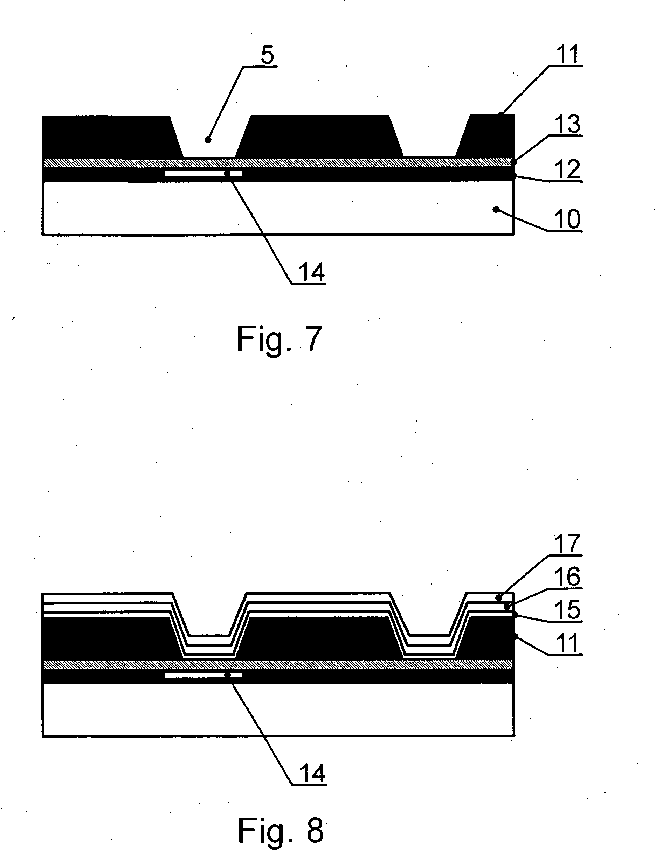

Figs. 7 to 10 show schematically a method of contacting wafer level packaged image sensors.

Fig. 7 shows plasma etching of tapered via holes and channel structures in silicon. The substrate comprises a silicon layer 11, onto which a resist layer 13 is applied as etch stop layer. Below the etched passage 5, there is also a layer of conductive material 14. A glass sheet 10 is mounted to silicon layer 11 preferably using a glue layer 12. Glass sheet 10 covers active elements (IC/sensors) of silicon layer 11.

Fig. 8 shows the deposition of passivation and IDL (Inter Dielectric Layer) layers. Two passivation layers 15, 16 are applied onto the silicon layer 11, wherein the first passivation layer 15 is deposited in a CVD process and the second passivation layer 16 is spray coated. A resist layer 17 is applied as final layer. In a subsequent process step, resist layer 17 is opened above the layer of conductive material 14.

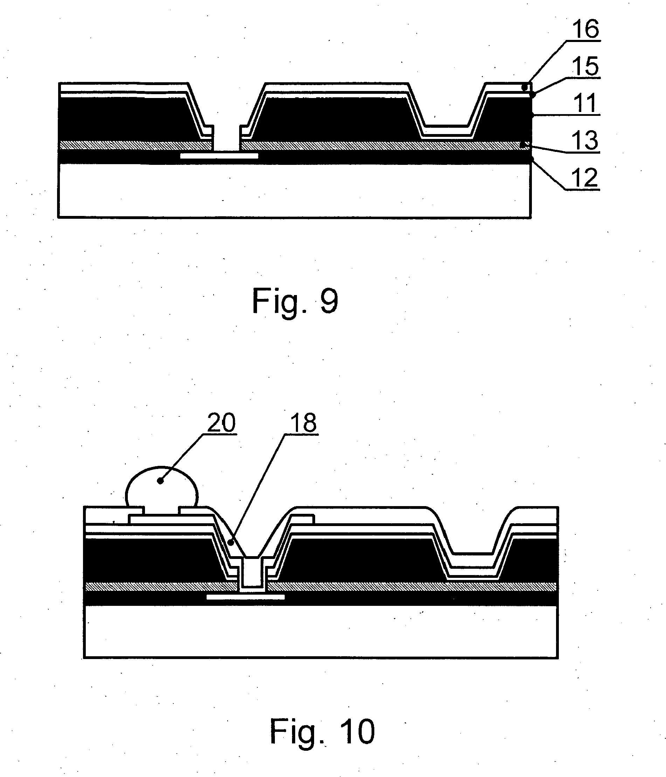

Fig. 9 shows plasma etching of the passivation and glue layers 12, 13 and 14, 15 in order to form a passage to the conductive material 14. In a subsequent step, the outer resist layer (17 of Fig. 8) is stripped.

As shown in Fig. 10, contact layers 18 are finally covered, preferably sputtered, with a metal layer and redistributed. A solder mask and bumpers 19 for contacting are applied.

These processes include plasma etching of via holes for the electrical contact to the front-end pads and the scribechannels, spray coating to create the contact window in this via holes and the metallization to redistribute the pad connections.

To have good uniformity and step coverage in spray coating, in lithographic processes and metallization inside the passages, a tapered sidewall is needed.

Passages with vertical sidewalls as normally seen in cryogenic-processes are not apt to be used, since it is difficult to obtain a good step coverage at the sharp corners in subsequent spray coating or sputtering processes.

KOH and TMAH are most common methods used to generate tapered passages in silicon since these are cheap and easy to use techniques. However, limitations of these techniques are the low etch rate (1 µm/min) and the inflexibility for different designs (fixed angle at 54,70°).

For microfluidic applications passages with tapered sidewalls can be used as diffusers or nozzles.

Use of channels with tapered sidewalls has obvious advantages such as simple geometry for calculation, higher possible flow rates and reduced thermal time constant.

It was discovered that it is easy to create tapered passages in silicon with a depth up to 30 µm with a SF₆/O₂ gas mixture. For passages deeper than 30 µm, the sidewall tends to show overhang, i.e. bowing.

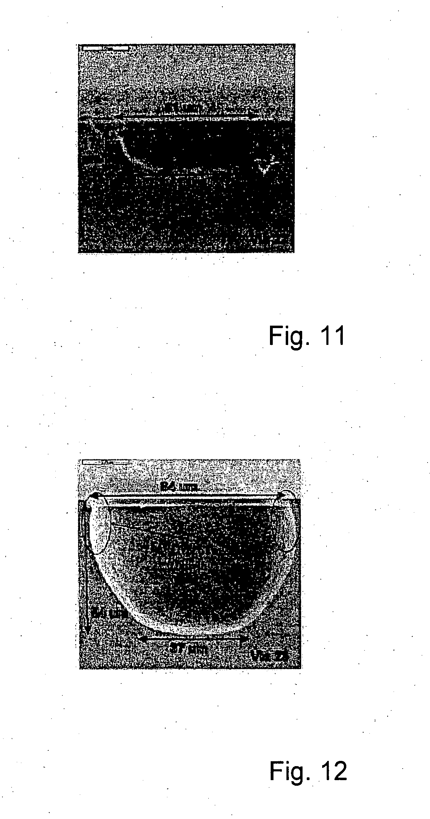

Figs. 11 and 12 show two passages etched with the same recipe but with different etch times.

The passage according to Fig. 11 was etched in a shorter time interval. The etch depth is about 17 µm. This passage has essentially no overhang or bowing.

The passage according to Fig. 12, was etched for a longer period of time and has an etch depth of about 54 µm and an overhang of about 20 µm.

This overhang or bowing is very critical for the next process steps as shown in Figure 8 to 10 such as spray coating, deposition of passivation layers and metallization since it causes a reduced or faulty coverage in this area.

The SF₆/O₂-Si system is believed to be an ion-inhibitor process. In this gas system, the oxygen induces the formation of a passivating layer on the silicon surface with silicon oxide.

The SF₅⁺ ions etch the passivator or passivating layer enabling F-radicals to etch the silicon substrate.

The possible causes of the overhang are believed to be:
Sidewall charging due to the fact that the passivation layer is an insulator (SiO₂), so that ions colliding with the sidewall will leave their charge, which is difficult to compensate with electrons. This charging can repel the next ions;
Ion deflection is most pronounced for SF₆/O₂ etch gas mixture. The negative potential of the passage walls deflect the ions to the sidewall;
Ion shadowing, when ions arrive under an angle the topside of the passages will block ions from etching the area under the mask layer.

It is believed that the ion deflection is the main driving force for the overhang formation in the via profile (bowing).

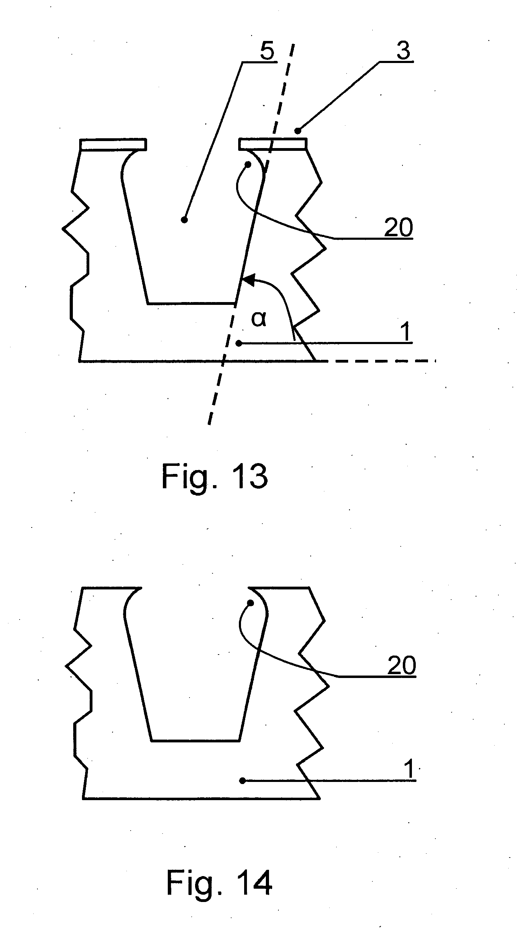

Fig. 13 to 15 show a multistep etching method.

As shown in Fig. 13, as a first step a passage 5 with an overhang 20 is etched into the substrate. In this first initial step, a profile having bowing has been generated with SF₆/O₂ -plasma (10% O₂). The typical etching rate in this step is higher than 10µm/min (for 5% etch area).

The sidewall angle α is defined as the angle between the surface of the substrate and the sidewall of the passage 5.

As shown in Fig. 14, the mask (3 in Fig.. 11) layer is removed by pure oxygen plasma.

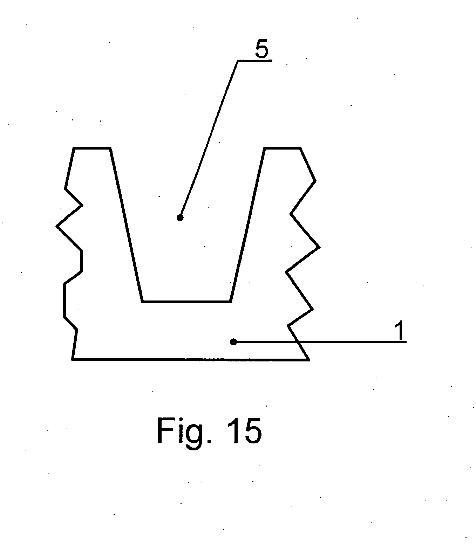

Referring to Fig. 15, as the final step, an isoptropic etching step with SF₆- plasma is performed to remove overhang (20 of Fig. 11 and 12) and to achieve the final passage geometry.

The stress containing silicon layer with crystal dislocation as potentially generated in a mechanical thinning step, can be avoided to guarantee an improved and reliable package performance.

In a further step, the etch mask has been removed in pure oxygen plasma.

In a last etch step, the final profile has been achieved in an isotropic etch step (SF₆ plasma).

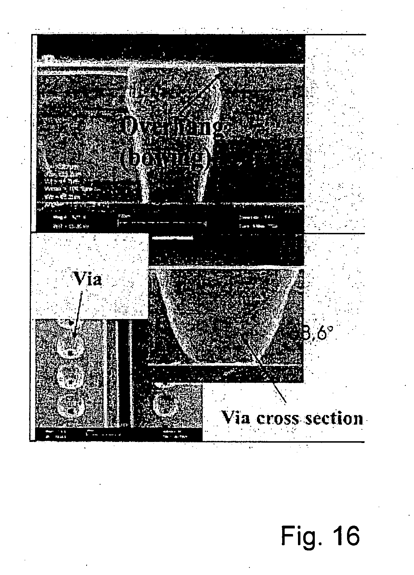

Fig. 16 shows pictures of results of a multistep etching method performed according to an embodiment of the invention as shown Figs. 13 to 15.

The sidewall angles are adjustable at least in the range of 55-75°.

The roughness inside the passages is excellent («200nm peak to valley).

The selectivity of silicon to resist is higher than 50.

The ion deflection can be minimized by increasing the sidewall passivation, wall charging and/or the energy of the ions before entering into the passages. This effect can be achieved by adding an extra passivation gas (e.g. C₄F₈ or CHF₃).

A C₄F₈ glow discharge produces chemically reactive polymer precursor species, which can be employed to deposit a blocking polymer film isotropically above the wafer surface.

Due to the fact that the passivation material is a FC-polymer, effects such as ion charging and ion deflection can be avoided.

Tapered profiles can be achieved in one step with this gas chemistry.

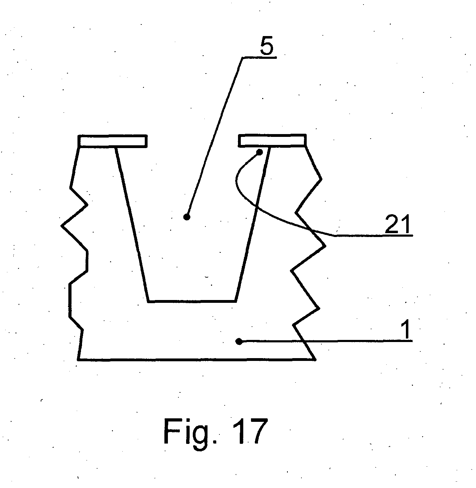

Fig. 17 shows schematically the etching of a passage 5 into a silicon substrate 1 using a SF₆/O₂/C₄F₈ gas mixture. An undercut 21 is built below the mask, but nearly no overhang can be seen.

Fig. 16 shows the result of this etching method. Using an 8-inch waver material, the roughness inside the passage is about 3 µm (peak to valley). The selectivity of silicon to resist is about 80.

The SF₆/O₂/C₄F₈ gas mixture provides essential easy design improvements. Nevertheless, the roughness inside the passage is critical for some applications. The typical roughness is about 3 µm using this gas mixture.

For applications requiring good roughness qualities such as microfluidic or electronic packages, an extra smoothing step is needed.

As an alternative, a SF₆/O₂/CHF₃ gas mixture can be used. This gas chemistry enables passivation of the silicon surface with silicon oxide and polymer (FC fluorocarbon).

The gas CHF₃ is not only the source of the fluorocarbon polymer passivating the silicon surface but also the source of CF- ions, which in turn are responsible for the removal of SiOₓF_{y} layers at the bottom of the passages, forming the volatile COₓF_{y}. The F:C ratio in this case is 3, so the FC polymer is not as stable as the FC polymer deposited by C₄F₈ discharge (F:C ratio 2) and can be removed by O₂ completely.

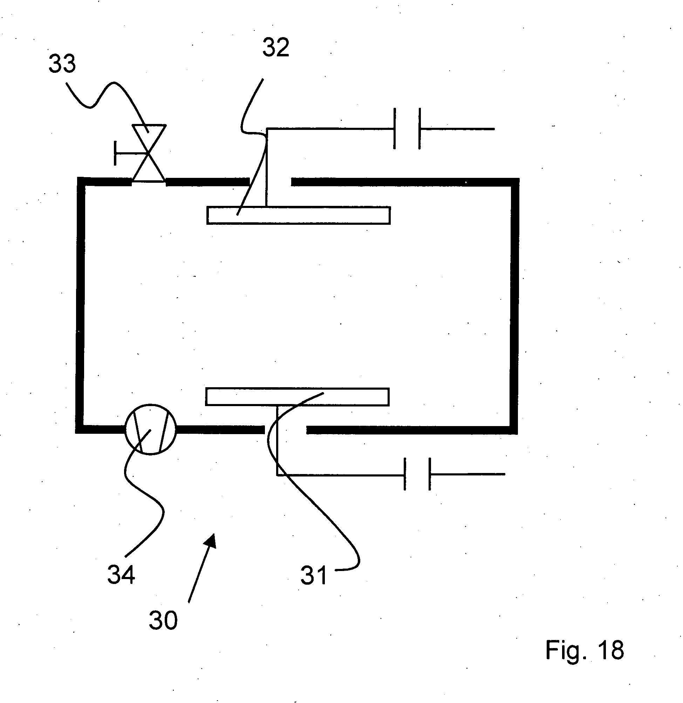

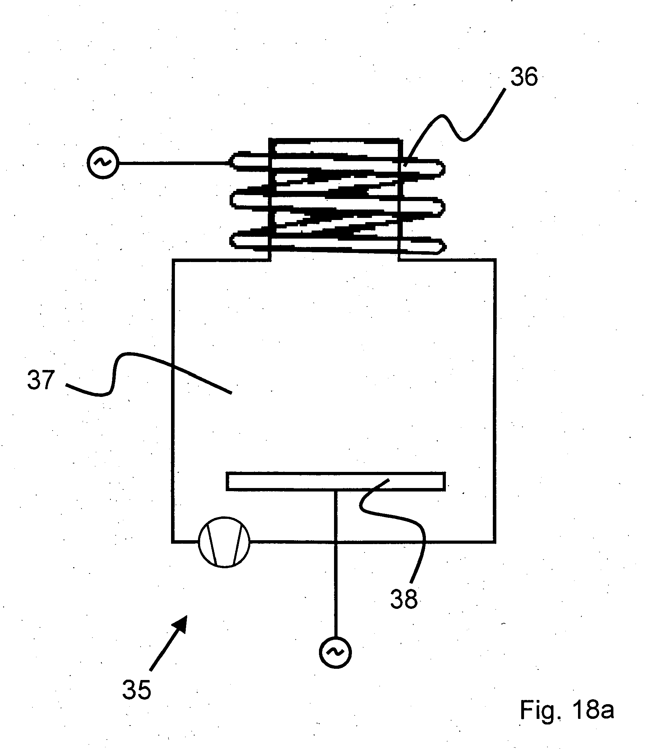

Fig. 18 shows schematically a plasma source 30 used for plasma etching according to the invention.

The plasma source 30 comprises a lower electrode 31 and an upper electrode 32, which are connected with a power generator (not shown), a gas inlet 33 and a pump 34.

Preferably, instead of the direct etch plasma chamber according to Fig. 18, a inductive coupled plasma chamber is used.

An inductive coupled plasma source 35 is schematically shown in Fig. 18a. Such type of plasma source in which the energy is supplied by electrical currents which are produced by electromagnetic induction, that is, by time-varying magnetic fields. The inductive coupled plasma source 35 comprises a coil 36 outside and an electrode 38 inside the plasma chamber 37. When a alternating electric current is passed through the coil 36, it causes a time varying magnetic field, which results in formation of a plasma.

A so-called dark sheath is formed in the neighborhood of all surfaces in the reactor, which are grounded, electrodes and walls. This dark sheath can be considered as some kind of dielectric or as some kind of capacitor. So one may assume that the applied power is transmitted to the plasma through a capacitor. The process gas can be guided into the plasma source through gas inlet 33.

According to the invention, all known kinds of plasma sources can be used, e.g. HF, microwave etc.

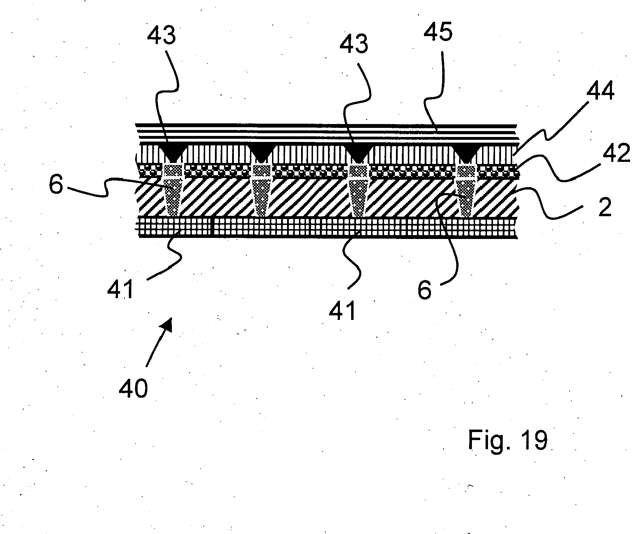

Fig. 19 shows schematically a cross section of an area of a photosensitive device 40, in particular an image sensor comprising pixels 41. Each pixel 41 comprises a photosensitive charge coupled device and is backside contacted via passages. Said passages are filled with conductive material 6 and are etched with an etching method according to the invention.

Each pixel 41 is connected via said passages with an amplifier 43. The amplifiers 43 are provided as an integrated circuit layer 44, comprising single ICs. Said integrated circuit layer 44 is bonded via a layer of adhesive material 42 onto the substrate 2.
A contact layer 45 is provided as integrated circuit layer. Said contact layer is connected with the amplifiers 43.

Since said amplifiers 43 are closely placed to said pixels 41, the signals are amplified substantially directly and immediately after their formation. The amplified signals are less sensitive to common noise.

The signals of the amplifiers 43 are transmitted via a contact layer 45. To transmit the signals of the amplifiers, the contact layer 45 comprises a bucked brigade circuit (Eimerkette).

Due to the fact that the bucked brigade circuit processes already amplified signals, the signal are less sensitive to noise e.g. induced by said bucked brigade circuit. Accordingly the noise of said photosensitive device is reduced substantially.

The bucket brigade circuit is connected to solder contacts (not shown).

Alternatively, according to another embodiment of the invention (not shown), the pixels are contacted with amplifiers and the amplifiers are contacted directly. Without any bucket chain circuit, the repetition rate of the photosensitive device might be increased considerably.

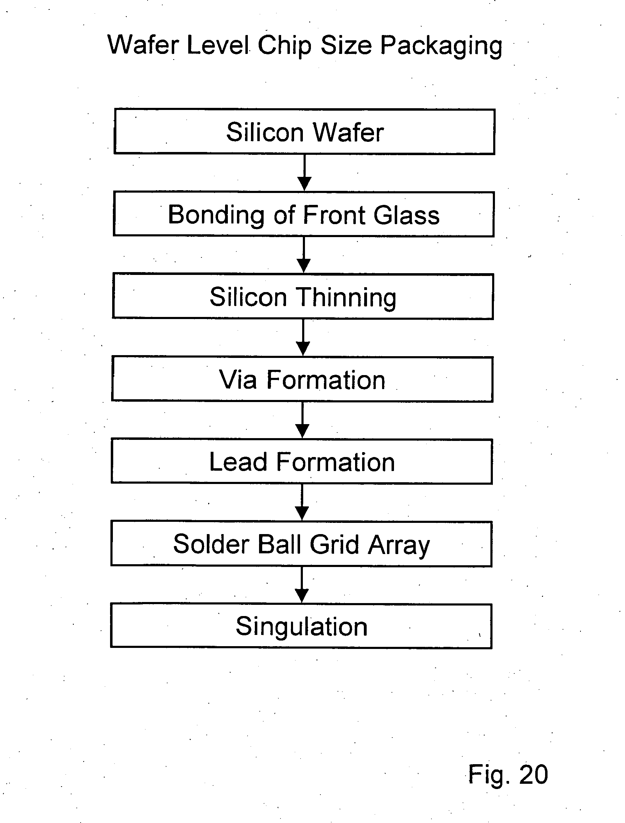

Fig. 20 shows a flow chart of a method of wafer level chip size packaging according to one exemplary embodiment of the invention. This method is used, in particular, for manufacturing a packaged CCD image sensor.

As shown in Fig. 20, a silicon wafer is bonded with its front side onto a glass sheet. As next step, the silicon layer, which is supported by the glass sheet, is thinned.

For contacting, e.g. pixels of a CCD sensor, vias are formed in the silicon layer. The pixels are contacted with lead to a solder ball grid array. The solder ball grid array enables contacting of the sensor package.

As last step the chips are singulated, e.g. by dicing.

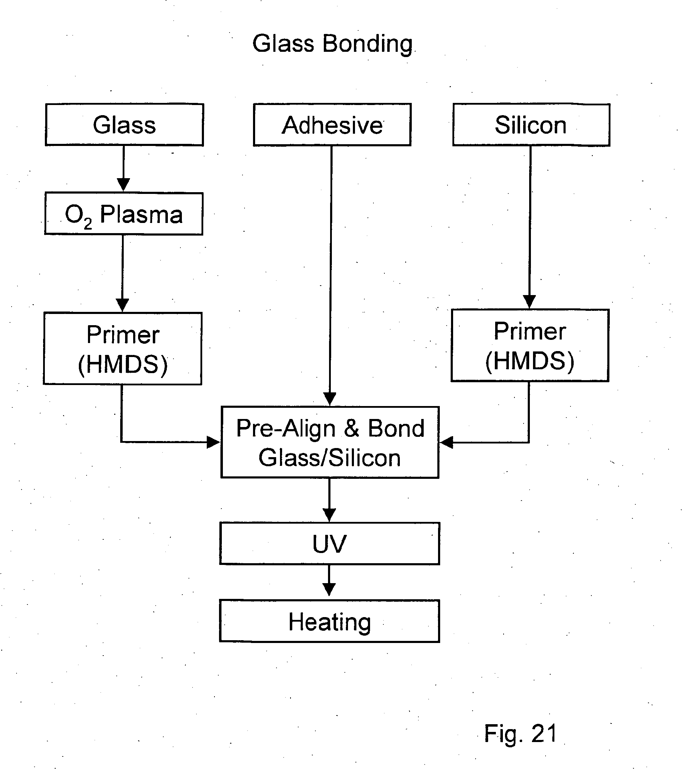

Referring to Fig. 21 the step of bonding glass sheet and silicon layer is shown in more detail.

The glass sheet is treated with a plasma comprising oxygen for activating the glass surface.

As next step, silicon and glass layer are pretreated in a CVD process. As precursor gas is used HMDS (Hexadimethyldisizan) for example.

Glass and silicon layer are aligned and bonded with an adhesive. The adhesive is cured by UV radiation and heating.

The glass sheet acts as optical element, e.g. for image sensors and protects as carrier the silicon wafer.

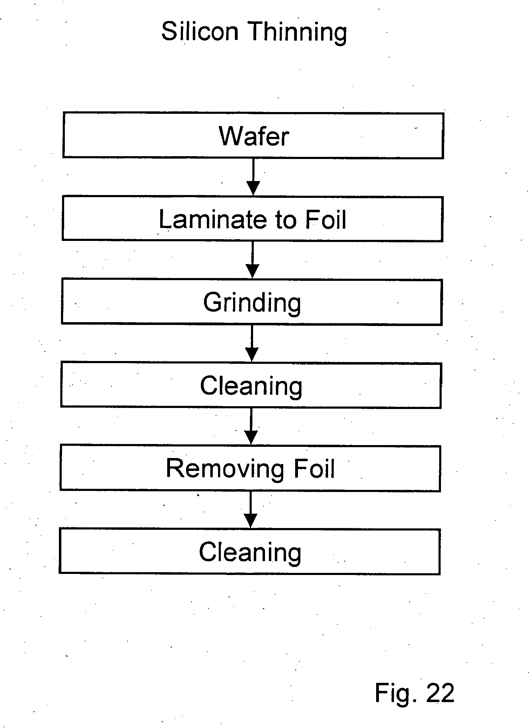

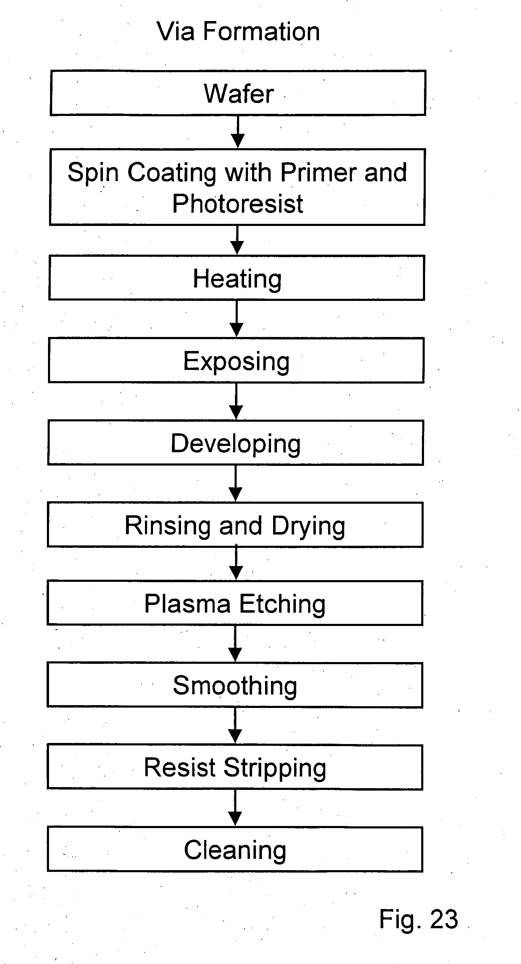

With reference to Fig. 22 and 23, the steps of forming vias are shown according to an exemplary embodiment of the invention in more detail.

Fig. 22 shows exemplary the steps of thinning the silicon layer. The wafer is laminated to foil and the silicon layer is thinned by grinding to a thickness between 50 and 180 µm. The grinding may be performed in several steps with different feed to achieve a better accuracy.

Due to the fact that the glass layer acts as carrier of the silicon layer, it is possible to manufacture substantially uniform silicon layers with a thickness below 100 µm.

After grinding, the wafer is cleaned, the foil is removed and the wafer is cleaned again.

With reference to Fig. 23, the steps of applying the lithography for silicon structuring are shown in detail. The wafer is spin coated with primer. The photoresist is heated at 90 °C for about 30 min, exposed and developed.

After rinsing and drying, vias and passages for electronic structured are etched with an etching method according to the invention. The plasma etching process is performed in an one step or two step strategy. By etching in an one step strategy, the etching rate will be typically set lower. Accordingly, a second etching step for reducing overhang (bowing) may not be necessary.

The sidewall angle of etched structures is typically 70°. The thickness of the silicon layer may be reduced further in the etching process. With this steep sidewall angle, backside contacting of small structures, e.g. image sensors like CCD chips, is possible.

The wafer after performing these steps is shown in Fig. 7.

Resist stripping is performed with an oxygenic plasma.

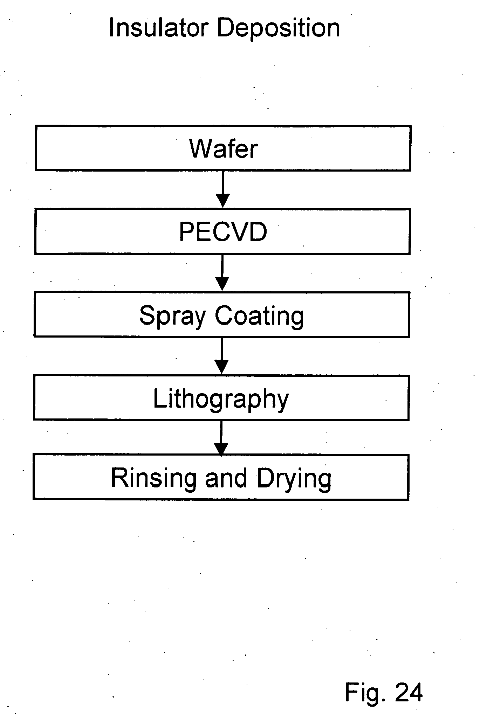

Referring to Fig. 24, an insulating layer is deposited with a low temperature PECVD (plasma enhanced chemical vacuum deposition) process onto the structured wafer surface. This SiO insulating layer has a thickness typically of 2µm on top and 1µm inside the vias.

For lithography, further layers are applied in a spray coating process. These layers have a typical thickness of 20µm on top and 1-2µm inside the vias.

The wafer now corresponds to Fig. 8.

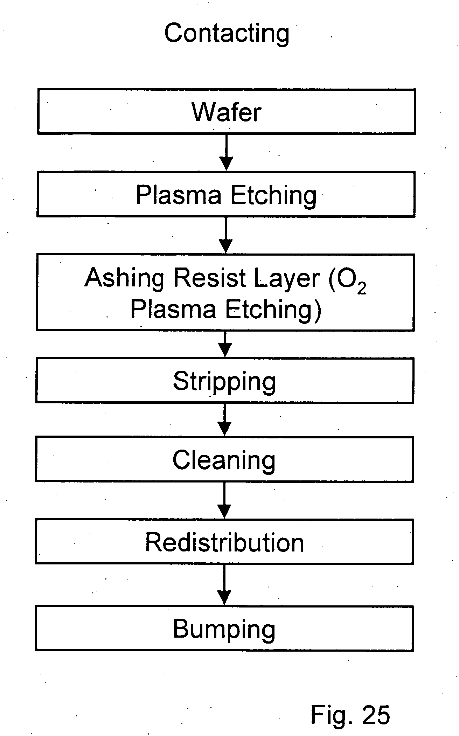

With reference to Fig. 25, the flow chart shows the steps for contacting e.g. the pixels of the chip in detail. With a plasma etching process, using a CF₄/C₄F₈/He plasma, the insulating layer is removed to contact the pixel (as shown in Fig. 9)

To ash the hardened resist layer on top, a oxygenous plasma is applied.

The resist layer is now stripped.

The wafer now corresponds to Fig. 8.

As next steps, Al leads are sputtered to fill the vias (redistribution). The formation of Al vias to provide electronic structures is performed with conventional thin-film methods, including wet etching processes, and is not explicitly shown.

The wafer now corresponds to Fig. 9.

To provide contacts for a CCD chip, a solder ball grid array is applied (bumping).

The wafer now correspond to Fig. 10. Finally the chips are singulated.

It will be apparent to a person skilled in the art that modifications to and variations of the above-described methods and apparatus are possible without departing from the inventive concept disclosed herein.

### Numerals:

- 1: substrate
- 2: chip
- 3: mask
- 4: opening
- 5: passage
- 6: conductive material
- 10: glass sheet
- 11: silicon layer
- 12: glue layer
- 13: resist layer
- 14: conductive material
- 15: first passivation layer
- 16: second passivation layer
- 17: resist layer
- 20: overhang
- 21: undercut
- 30: plasma source
- 31: lower electrode
- 32: upper electrode
- 33: gas inlet
- 34: pump
- 40: photosensitive device
- 41: pixel
- 42: adhesive layer
- 43: amplifier
- 44: IC layer
- 45: contact layer

## Claims

1. Method of plasma etching of at least parts of a substrate, comprising:
- providing a substrate,
- applying at least one structured mask comprising openings onto said substrate,
or
- applying at least one mask onto said substrate and
defining openings in said mask by structuring said mask,
- removing material from said substrate at least in said openings by a plasma etching process using a process gas comprising at least one halogenide and oxygen.

2. Method of plasma etching of at least parts of a substrate according to claim 2,
**characterized in that**
the amount of oxygen in said process gas is less than 40 % preferably below 30 %, particularly preferred below 25 % expressed as volume percentage of the gasses.

3. Method of plasma etching of at least parts of a substrate according to one of the preceding claims,
**characterized in that**
the ratio of said oxygen relative to said halogenide is less than 30 %, preferably below 25 %, in particular preferred below 20 % (volume percentage).

4. Method of plasma etching of at least parts of a substrate according to one of the preceding claims, **characterized in that** said halogenide is provided as a sulfur halogenide.

5. Method of plasma etching of at least parts of a substrate according to claim 2, **characterized in that** said sulfur halogenide is provided as SF₆.

6. Method of plasma etching of at least parts of a substrate according to one of the preceding claims, **characterized in that** said substrate comprises a semiconductor material.

7. Method of plasma etching of at least parts of a substrate according to one of the preceding claims, **characterized in that** said substrate comprises silicon.

8. Method of plasma etching of at least parts of a substrate according to one of the preceding claims, **characterized in that** said substrate is a wafer.

9. Method of plasma etching of at least parts of a substrate according to one of the preceding claims, **characterized in that** said mask comprises a photoresist.

10. Method of plasma etching of at least parts of a substrate according to one of the preceding claims, **characterized in that** said mask is a photolithographic mask.

11. Method of plasma etching of at least parts of a substrate according to one of the preceding claims, further comprising the step of lifting off said mask.

12. Method of plasma etching of at least parts of a substrate according to one of the preceding claims, wherein etching of said substrate is performed in at least two etching steps.

13. Method of plasma etching of at least parts of a substrate according to one of the preceding claims, wherein a first etch step has a higher etching rate than a following second etching step.

14. Method of plasma etching of at least parts of a substrate according to one of the preceding claims, wherein the amount of said oxygen is reduced in the second etching step.

15. Method of plasma etching of at least parts of a substrate according to one of the preceding claims, wherein the substrate is etched in a final etching step, using a process in this final etching step comprising no oxygen.

16. Method of plasma etching of at least parts of a substrate according to claims 1 to 11, wherein etching of at least one passage into said substrate is performed in one etching step.

17. Method of plasma etching of at least parts of a substrate according to one of the preceding claims, **characterized by** an etch rate of said etching process between 5 and 500 µm/min, preferably between 7 and 100 µm/min, in particular preferred between 8 and 20 µm/min.

18. Method of plasma etching of at least parts of a substrate according to one of the preceding claims, **characterized in that** said process gas further comprises CHF₃.

19. Method of plasma etching of at least parts of a substrate according to one of the preceding claims, **characterized in that** said process gas further comprises C₄F₈.

20. Method of plasma etching of at least parts of a substrate according to one of the preceding claims, **characterized by** etching at least one passage through said substrate.

21. Method of plasma etching of at least parts of a substrate according to one of the preceding claims, **characterized by** etching at least one tapered passage through said substrate.

22. Method of plasma etching of at least parts of a substrate according to one of the preceding claims, **characterized in that** said tapered passage defines a sidewall angle relative to the surface of said substrate, wherein said sidewall angle is adjusted between 50° and 90°, preferably between 60° and 85°, in particular preferred between 65° and 80°.

23. Method of plasma etching of at least parts of a substrate according to one of the preceding claims, **characterized by** a peak to valley roughness of the sidewalls of said passages below 200 nm, preferably below 100 nm, in particular preferred below 50 nm.

24. Method of plasma etching of at least parts of a substrate according to one of the preceding claims, **characterized in that** the surface roughness of the sidewalls of said passages is below 100 nm, preferably below 30 nm, in particular preferred below 10 nm if said surface roughness is expressed as a standard surface roughness Rₐ of the sidewalls.

25. Method of plasma etching of at least parts of a substrate according to one of the preceding claims, **characterized by** forming at least one passage having a diameter between 10 µm and 500 µm, preferably between 15 and 100 µm, in particular preferred between 18 and 70 µm.

26. Method of plasma etching of at least parts of a substrate according to one of the preceding claims, wherein said passage defines an overhang below said mask, wherein a diameter of said passage is larger than the diameter of said opening, **characterized in that** the difference of said diameter of the opening and said a diameter of said passage is less than 10 µm, preferably less than 5 µm, in particular preferred below 2 µm.

27. Method of plasma etching of at least parts of a substrate according to one of the preceding claims, wherein said sidewalls are at least partially passivated.

28. Method of plasma etching of at least parts of a substrate according to one of the preceding claims, wherein said passivation is achieved by adding a passivation gas to said process gas.

29. Method of plasma etching of at least parts of a substrate according to one of the preceding claims, wherein said passivation gas comprises at least one carbon comprising chemical compound.

30. Method of plasma etching of at least parts of a substrate according to one of the preceding claims, wherein said passivation gas comprises C₄F₈ and/or CHF₃.

31. Method of plasma etching of at least parts of a substrate according to one of the preceding claims, **characterized in that** said overhang is controlled by the power of the plasma source.

32. Method of plasma etching of at least parts of a substrate according to one of the preceding claims, further comprising the step of thinning said substrate.

33. Method of plasma etching of at least parts of a substrate according to one of the preceding claims, **characterized in that** said material in said substrate is removed to a depth of between 5 µm and 500 µm, preferably of between 20 and 200 µm, in particular preferred of between 80 and 160 µm.

34. Method of plasma etching of at least parts of a substrate according to one of the preceding claims, **characterized by** generating said plasma with an inductively coupled plasma (ICP) source.

35. Method of plasma etching of at least parts of a substrate according to one of the preceding claims, **characterized in that** said mask is structured with a stepper.

36. Method of plasma etching of at least parts of a substrate according to one of the preceding claims, further comprising the step of smoothing the substrate surface.

37. Method of plasma etching of at least parts of a substrate according to one of the preceding claims, **characterized in that** the step of smoothing the substrate is performed by of etching, in particular by KOH-etching of the substrate surface.

38. Method of plasma etching of at least parts of a substrate according to one of the preceding claims, further comprising depositing at least one conductive layer onto said substrate.

39. Method of plasma etching of at least parts of a substrate according to one of the preceding claims, further comprising coating the substrate at least partially with at least one passivation layer.

40. Method of plasma etching of at least parts of a substrate according to one of preceding claims, **characterized in that** the amount of oxygen in said process gas is between 3 and 40 %, preferably between 5 and 30 %, in particular preferred between 10 and 20 % expressed as volume percentage of the gasses.

41. Method of plasma etching of at least parts of a substrate according to one of preceding claims, **characterized in that** the temperature of said substrate during said plasma etching process is below 200 °C, preferably below 150 °C, in particular preferred below 120 °C.

42. Method of plasma etching of at least parts of a substrate according to one of preceding claims, **characterized in that** said plasma etching process is performed discontinuously, in particular pulsed.

43. Method of plasma etching of at least parts of a substrate, in particular according to one of the preceding claims, comprising:
- providing a substrate,
- applying at least one mask onto said substrate,
- defining openings in said mask by structuring said mask, .
- removing material from said substrate at least in said openings by a plasma etching process.

44. Electronic component producible, in particular produced, according to one of the preceding method claims.

45. Wafer level package producible, in particular produced, with a method according to one of the preceding method claims.

46. Micro Electro Mechanical System (MEMS), producible, in particular produced, with a method according to one of the preceding method claims.

47. Micro Fluidic Device, producible, in particular produced, with a method according to one of the preceding method claims.

48. Filter, in particular molecular sieve, producible, in particular produced, with a method according to one of the preceding method claims.

49. Microprocessor producible, in particular produced, with a method according to one of the preceding method claims.

50. Sensor, in particular pressure sensor, producible, in particular produced, with a method according to one of the preceding method claims.

51. Cooler for microprocessors producible, in particular produced, with a method according to one of the preceding method claims.

52. Photosensitive device, in particular charge-coupled photosensitive device (CCD) or complementary metal oxide semiconductor (CMOS), producible, in particular produced, with a method according to one of the preceding method claims.

53. Photosensitive device according to one of the preceding claims, comprising at least one array of photosensitive elements defining pixels of said photosensitive device, wherein said photosensitive elements are rear side contacted.

54. Photosensitive device according to one of the preceding claims, **characterized in that** said pixels are rear side contacted and electrically connected with amplifiers.

55. Photosensitive device according to one of the preceding claims, **characterized in that** at least one amplifier is assigned to each pixel.

56. Photosensitive device according to the preceding claim, wherein said amplifiers are rear side contacted and/or connected in a bucket brigade circuit (Eimerkette).

57. Photosensitive device according to the preceding claim, wherein said amplifiers are cascade type amplifiers.

58. Photosensitive device according to the preceding claim, wherein said photosensitive device comprises a photomultiplier, in particular a secondary electron multiplier for photomultiplying.

59. Photosensitive device, in particular photosensitive device according to one of the preceding claims, comprising at least one array of photosensitive elements defining pixels of said photosensitive device, said photosensitive elements being rear side contacted with amplifiers, **characterized in that** at least one amplifier is assigned to each pixel.
